# EUROPEAN PATENT SPECIFICATION

(11) **EP 0 629 715 B1**
(45) Date of publication and mention of the grant of the patent: **28.01.1998**
(21) Application number: 94830271.6
(22) Date of filing: 31.05.1994
(51) Int. Cl.: C23C 14/56, C23C 14/08, B65D 65/00

(54) **Apparatus for continuous reactive metal deposition in vacuum and its application**
Vorrichtung zur kontinuerlichen reaktiven Metallbeschichtung im Vakuum und ihre Anwendung
Dispositif pour la déposition réactive de métal sous vide en régime continu et son application

(43) Date of publication of application: 21.12.1994
(73) Proprietor: CE.TE.V. CENTRO TECNOLOGIE DEL VUOTO, I-61067 Carsoli (AQ) (IT)
(72) Inventor: Misiano, Carlo, I-00161 Roma (IT); Simonetti, Enrico, I-00146 Roma (IT)

(56) References cited:
- EP-A- 0 328 257
- EP-A- 0 460 966
- DE-A- 3 046 564
- DE-A- 3 738 722
- US-A- 2 665 228
- US-A- 4 416 217

## Description

The invention concerns an apparatus to be used for reactive metal deposition in continuous vacuum equipments and a respective process. This invention overcomes the incoveniences found in preceding solutions as the substrate to be treated moves in a roll system, devised in a way to allow the metal to deposit from a reaction of reactive gas, possibly ionised and/or excited.

In the last times the request for dielectric deposition films, especially on plastic flexible substrates increased.

A typical example is the coating by dielectric film of plastic sheets (for example PE, PET, OPP) to realise barrier for oxygen and water vapour, transparent, for products destined to alimentary packaging; products sensible to oxygen and water vapour.

However, dielectric films depositions, generally oxides, present remarkable difficulties in the process, when physical vapour deposition techniques (PVD: crucible evaporation, electron gun evaporation, sputtering, etc.); or chemical vapour deposition phase (CVD) is used.

These problems are often connected to the difficulties caused by high speed deposition of said materials.

A well known method to overcome problems of dielectric direct deposition is to vaporise metals in gaseous reactive environment, thereby obtaining, for instance, oxides or nitrides from these metals.

This kind of process, well known in the thin films field, involves however, a restriction in the maximum speed of metal deposition, as the metal needs the time to completely react with the gaseous environment, optionally activated by ionisation and/or excitement.

In the plastic film coatings, however, in continuous plants, constituted with traditional configurations such as described in documents US-A-2 665 228 and DE-A-3 046 564, it results to be quite impossible. In fact, the substrate sliding speed must be at least some metres per sec. and to obtain the desired thickness of some tens mm (hundreds Å) of dielectric, the instantaneous metal deposition rate is too high to obtain a complete reaction, as the operation is made at a pressure below 0.133 Pa (10⁻³Torr).

It is the principal object of the present invention that the substrate maintains a sliding high speed providing a complete reaction of the metal, as the period in which the substrate is submitted to the oxidation is largely amplified by means of a series of short metal depositions followed by a long running in a reactive ambient.

It is possible moreover, by traditional methods, that the pressure, in the deposition zone, results notably lower than that one obtained in the reaction zone, favouring on one hand the reactive processes, which are proportional to the partial pressure of reactive gas, on the other hand in a way that the depositing material does not suffer excessive interactions with the gaseous residual ambient which reducing energy, causes deterioration in deposed film compactness and its barrier properties thereto.

The invention here presented is essentially constituted by a vacuum chamber 1 properly pumped, a sliding system for the plastic film, a system of rolls 3, 3a with many returns which has the task to increase the interaction surface of some orders of magnitude, a metal vaporisation device 6, a reactive gas introducing device, which can be activated by a variety of methods (i.e. UV sources, DC or RF discharge, microwave, ECR, ionic or plasma guns), a physical screen 7 able to separate Z1 and Z2 zones wich are at different pressures.

A release of the invention, currently preferred by the inventors, is provided. It is evident however that different dimensions and configurations can be imposed provided the equipment maintains its characteristics which make it original.

One of its characteristic aspects is the increasing time in which the entire film is deposited in a reactive way on the substrate. This is due to the distance between the series of rolls 3 and 3a.

The above and other objects, features and advantages of the present invention will become more readily apparent from the following description, reference being made to the accompanying drawing in which:
Fig. 1 is a view of the equipment;
Fig. 2 is one of the possible rolls system configuration.

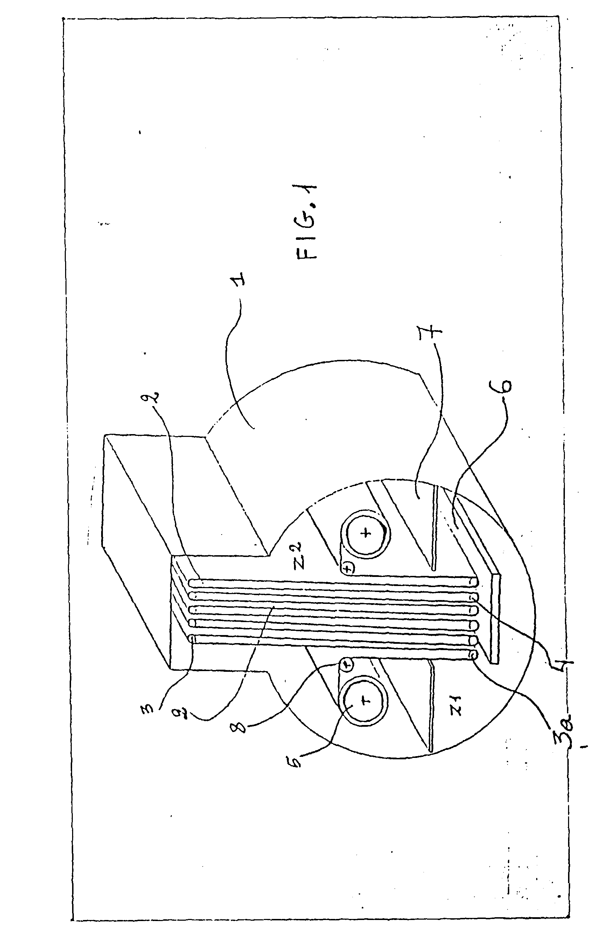

In Fig. 1:
1 vacuum chamber;
2 substrate carried through two series of rolls 3 and 3a;
3, 3a rolls;
4 portion of substrate surface exposed to the source;
5 substrate spool roll;
6 metal source;
7 physic screen between Z1 and Z2 zones;
8 return rolls

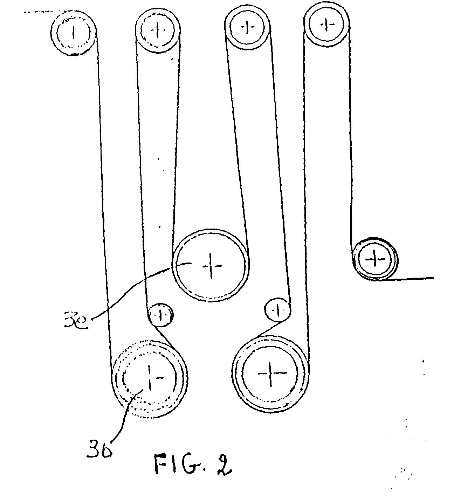

In Fig. 2:
3b rolls series
3c rolls series behind and screened in respect of the source.

One of the possible ways to realise coating by the equipment given above is described in the following:
Loading the spool of plastic material through the rolls system 3, 3a, such to assume a configuration like an accordion. The film 2 passes repeatedly the source for a short period and then transits in the reactive zone Z2 and is cyclically coming back attaining the coating end. The transits number is obviously equal to the number of the rolls. It is the principal object of the present invention to effect dielectric film deposition with high substrate speed, with vaporising sources at very low temperature and consequent abatement of work times and costs.

## Claims

1. Apparatus for reactive metal deposition upon a web of a plastic film, comprising:
a chamber with means for forming a vacuum in said chamber, adapted for containing in use a reactive atmosphere;
a plurality of spaced apart rollers in said chamber defining a path for said web through said chamber, said path including at least one loop;
a supply roll for feeding said web to said path;
a take-up roll for receiving said web from said path;
at least one source of metal vapour juxtaposed with only a first portion of said path for depositing in use a coating of said metal on said web,
said chamber being subdivided into two zones including a first zone containing said at least one source, said first portion of said path, and adapted to be operated in use at one pressure, and a second zone containing a second portion of said path and adapted to be operated in use at a higher pressure than said one pressure in said first zone such that said coating is in use reacting in said reactive atmosphere in said second portion of said path,
and means for exiting said reactive atmosphere in said second zone to promote reaction of the deposited metal therewith;
said rollers including a multiplicity of rollers in said first and second zones defining at least one loop of said web along said path, said path including at least one pass through said first zone whereby said web is juxtaposed with said at least one source and whereby in use said coated web passes through said reactive atmosphere in said second zone for reaction of the metal coating therewith;
said rollers further including an upper array of rollers and a lower array of rollers, said web being looped between upper and lower rollers of said arrays, some of the rollers of one of said arrays being placed lower than other rollers of said one of said arrays and being larger than rollers of the other of said arrays such that the curvature of said web, as said web in use passes around the rollers of said one of said arrays, is minimized.

2. Apparatus as defined in claim 1, characterized by the fact to comprise means for heating said rollers.

3. Apparatus as defined in claim 1, characterized by the fact to comprise means for cooling said rollers.

4. Apparatus as defined in claim 1, characterized by the fact that said rollers are located within the chamber.

5. Apparatus as defined in claims 1 - 4, characterized by the fact that there are provided a plurality of sources of metal vapour in said first zone, and/or a plurality of loops of said web along said path through said first and second zones.

6. Use of the apparatus of claims 1 - 5 in a process for reactive thin film deposition such as to provide a multiple step deposition/reactive atmosphere treatment cycle.

## Patentansprüche

1. Vorrichtung zur Ablagerung von reaktionsfaehigem Metall auf einem Kunststoffilmnetz mit: einer Kammer mit einem Mittel zur Bildung eines Vakuums in besagter Kammer, die dazu ausgelegt ist, eine reaktionsfaehige Atmosphaere zu enthalten;
mehreren untereinander distanzierten Rollen in besagter Kammer, die einen Pfad fuer besagtes Netz durch besagte Kammer ausbildet, wobei besagter Pfad mindestens eine Schlinge enthaelt;
einer Vorschubrolle fuer die Einfuehrung des besagten Netzes in den Pfad;
einer Aufnahmerolle zum Auffangen des besagten Netzes aus besagtem Pfad;
mindestens einer Metalldampfquelle, die nur dem ersten Abschnitt des besagten Pfades gegenuebergestellt ist, zur Aufbringung einer Verkleidung des besagten Metalls auf besagtem Netz,
wobei besagte Kammer in zwei Zonen unterteilt ist und eine erste Zone mindestens eine der besagten Quellen enthaelt, der besagte erste Abschnitt des besagten Pfades, die fuer den Betrieb bei einem bestimmten Druck ausgelegt ist, sowie eine zweite Zone mit einem zweiten Abschnitt des besagten Pfades, die fuer den Betrieb bei einem hoeheren Druck als der besagte Druck in der besagten ersten Zone ausgelegt ist, sodass die besagte Verkleidung in besagter reaktionsfaehiger Atmosphaere in dem besagten Abschnitt des besagten Pfades reagiert sowie mit Mitteln zur Erregung besagter reaktionsfaehiger Atmosphaere in der besagten zweiten Zone zur Ausloesung der Reaktion des abgelagerten Metalls;
wobei besagte Rollen mehrere Rollen in den besagten ersten und zweiten Zonen umfassen, die mindestens eine Schlinge des besagten Netzes laengs des besagten Pfades ausbilden, wobei besagter Pfad mindestens einen Durchlauf durch die besagte erste Zone umfasst, wodurch besagtes Netz mindestens einer Quelle gegenuebergestellt wird und wobei das verkleidete Netz die besagte reaktionsfaehige Atmosphaere in der besagten zweiten Zone zum Zwecke der Reaktion des Metallnetzes durchlaeuft;
wobei besagte Rollen des weiteren eine obere Reihe von Rollen sowie eine untere Reihe von Rollen umfassen, wobei besagtes Netz zwischen den oberen und den unteren Rollen der besagten Reihen verschlungen ist, wobei einige der Rollen einer der besagten Reihen niedriger als die anderen Rollen einer dieser Reihen angeordnet sind und groesser sind als die Rollen der anderen Reihe, sodass die Kruemmung des besagten Netzes bei Betrieb desselben um die Rollen einer der besagten Reihen herumfaehrt und auf ein Mindestmass reduziert wird.

2. Vorrichtung gemaess Patentanspruch 1, dadurch gekennzeichnet, dass sie Mittel zur Erhitzung der besagten Rollen enthaelt.

3. Vorrichtung gemaess Patentanspruch 1, dadurch gekennzeichnet, dass sie Mittel zur Kuehlung der besagten Rollen enthaelt.

4. Vorrichtung gemaess Patentanspruch 1, dadurch gekennzeichnet, dass die besagten Rollen innerhalb der Kammer angeordnet sind.

5. Vorrichtung gemaess Patentansorueche 1 - 4, dadurch gekennzeichnet, dass darin mehrere Quellen von Metalldampf in der besagten ersten Zone und/oder mehrere Schlingen des besagten Netzes laengs des besagten Pfades durch die besagte erste und zweite Zone vorhanden sind.

6. Benutzung der Vorrichtung gemaess der Patentansprueche 1-5 nach einem Verfahren zur Ablagerung eines duennen reaktionsfaehigen Films zur Schaffung von einem Behandlungszyklus mit Ablagerung in mehreren Phasen/reaktionsfaehiger Atmosphaere.

## Revendications

1. Appareil pour déposer une couche de métal réactif sur une bande de film plastique, comprenant:
une chambre avec des dispositifs permettant d'obtenir le vide dans cette chambre même, adaptée pour contenir en service une atmosphère réactive;
plusieurs cylindres espacés dans ladite chambre définissant un parcours de la bande susdite à travers la chambre, un tel parcours comprenant au minimum une boucle;
un cylindre émetteur pour alimenter la bande en question pendant le parcours prévu;
un cylindre enrouleur pour embobiner la bande après son parcours dans la chambre;
au moins une source de vapeur métallique juxtaposée seulement le long du premier tronçon dudit parcours pour déposer en service une couche du métal concerné sur ladite bande;
la chambre dont il est question étant répartie en deux zones: la première de ces zones comprend une source au moins du type de celle précisée ci-devant, un premier tronçon du parcours, et elle est prédisposée à fonctionner en service à une pression donnée; la seconde zone contenant un deuxième tronçon dudit parcours et elle est prédisposée à fonctionner en service à une pression plus élevée que celle de la première zone de manière que la couche concernée soit réactive en service dans l'atmosphère réactive prévue dans ce deuxième tronçon du parcours dans la chambre,
et des dispositifs pour décharger ladite atmosphère réactive dans la deuxième zone susmentionnée, afin de promouvoir par là la réaction du métal déposé;
les cylindres dont il a été question sont plusieurs dans lesdites première et deuxième zones définissant au moins une boucle de la bande concernée le long de son parcours, parcours comportant au moins un passage à travers ladite première zone tout au long de laquelle la bande même est juxtaposée à une source au moins, ainsi qu'il a été précisé, et où cette même bande chargée d'une couche en service passe au travers de l'atmosphère réactive prévue dans la deuxième zone afin que cela produise la réaction de la couche de métal;
lesdits cylindres comportent aussi des éléments supérieurs de cylindres et des éléments inférieurs de cylindres, la bande concernée étant mise en boucle entre ces deux systèmes d'éléments de cylindres, supérieur et inférieur, certains des cylindres de l'un desdits systèmes d'éléments étant placés plus bas que les autres cylindres de l'un desdits systèmes d'éléments et étant plus larges que les cylindres de l'autre desdits systèmes d'éléments de façon que l'incurvation de la bande prévue, lorsque, en service, elle passe autour des cylindres dudit système d'éléments des deux qui existent, soit minimisée.

2. L'appareil tel qu'il est défini à la sollicitation 1, se caractérisant du fait d'inclure des dispositifs pour chauffer lesdits cylindres.

3. L'appareil tel qu'il est défini à la sollicitation 1, se caractérisant du fait d'inclure des dispositifs pour refroidir lesdits cylindres.

4. L'appareil tel qu'il est défini à la sollicitation 1, se caractérisant du fait que lesdits cylindres sont placés à l'intérieur de la chambre.

5. L'appareil tel qu'il est défini aux sollicitations 1-4, se caractérisant du fait qu'y sont fournies plusieurs sources de vapeur métallique dans ladite première zone, et/ou plusieurs boucles de ladite bande le long dudit parcours à travers lesdites première et deuxième zone.

6. Utilisation de l'appareil tel qu'il apparaît des sollicitations 1 - 5 dans un procédé permettant de déposer un film à couche mince réactif de façon à proposer un cycle de traitement dépôt/atmosphère réactive à positions multiples.
